# EUROPEAN PATENT SPECIFICATION

(11) **EP 3 929 706 B1**
(45) Date of publication and mention of the grant of the patent: **14.05.2025**
(21) Application number: 21158564.1
(22) Date of filing: 23.02.2021
(51) Int. Cl.: G06F 3/04847, G06F 3/0481, G06F 3/023, G06F 3/04895, G01R 13/00

(54) **USER INTERFACE CONTROL DEVICE AND METHOD FOR CONTROLLING A USER INTERFACE**
VORRICHTUNG ZUR STEUERUNG EINER BENUTZEROBERFLÄCHE UND VERFAHREN ZUR STEUERUNG EINER BENUTZEROBERFLÄCHE
DISPOSITIF DE COMMANDE D'INTERFACE UTILISATEUR ET PROCÉDÉ DE COMMANDE D'UNE INTERFACE UTILISATEUR

(30) Priority: 26.06.2020 US 202016913894
(43) Date of publication of application: 29.12.2021
(73) Proprietor: Rohde & Schwarz GmbH & Co. KG, 81671 München (DE)
(72) Inventor: Lang, Florian, 82205 Gilching (DE); Steffke, Ottmar, 82256 Fuerstenfeldbruck (DE)
(74) Representative: Novagraaf Group

(56) References cited:
- KR-A- 20140 093 390
- US-A1- 2015 193 585
- US-A1- 2019 339 804

## Description

### TECHNICAL FIELD OF THE INVENTION

The invention relates to a user interface control device and to an electronic instrument comprising such a device. The invention further relates to a method for controlling a user interface.

### BACKGROUND OF THE INVENTION

Many electronic measurement devices, such as spectrum analyzers, are adapted to receive and analyze electronic signals. Such devices typically have a user interface, which allows a user to make settings or select modes of the device. Often, such user interfaces comprise several buttons on a front panel of the device. Each button of the user interface can be a single-function button that is assigned to a specific setting or mode of the device.

However, a large number of buttons increases the complexity and overall cost of the measurement device. In addition, a large number of buttons can make it difficult to intuitively operate the device and can lead to wrong user input.

The document EP 2 837 992 A1 discloses a user interface interaction method and apparatus applied in a touch screen device. Thereby, at least two single-function buttons on a user interface of the touchscreen device are combined into a multi-function button. A type of touch operation on the multi-function button is, for instance, determined according to a time of the touch operation. However, an inexperienced user of such an interface might not know for how long the multi-function button needs to be touched to initiate the different types of touch operations. This could lead to wrong user input, for example, if the button is unintentionally touched for too long.

The document WO 03/041371 A1 discloses a method and an apparatus for a name search from a personal information database. Thereby, various methods to input letters on a keypad are disclosed, for example a selection of letters based on a length of a keystroke. While the key is pressed, a temporary bar can be displayed showing the letters that are selectable with that key. However, the user does not intuitively know for how long he has to press the key to switch through the letters, such that a wrong input can be given if the key is pressed for too long.

The document US 2015/0193585 A1 discloses a system including a breathing apparatus, a touch screen unit and a processing unit. Thereby, a first content is displayed at a first screen location of the touch screen. Upon a user input, comprising a gesture of one or more gestures, at the first screen location, a second content related to the first content is selected and displayed in dependence of the gesture and the first content.

The document KR 2014 0093390 A discloses a method for inputting a command by long press using a touch screen in a user interface of a multifunctional apparatus.

Thus, it is an objective to provide an improved user interface control device, an improved electronic instrument, and an improved method for controlling a user interface, which avoid the above-mentioned disadvantages.

The object is solved by the features of the first independent claim for the user interface control device frontend and by the features of the second independent claim for the method.

### SUMMARY OF THE INVENTION

The object of the present invention is achieved by the solution provided in the enclosed independent claims. Advantageous implementations of the present invention are further defined in the dependent claims.

According to a first aspect, the invention relates to an electronic intrument according to claim 1.

This achieves the advantage that an electronic instrument with a user interface control device is provided that can be controlled in a simple and intuitive way. In particular, because a single input key can have different functions, no extra keys for each function is required. Due to the visual feedback during pushing the key, the user knows which function is assigned to the key when it is released and, thus, wrong user input can be avoided.

The user interface control device can be integrated in or connected to the electronic instrument. The user interface control device can be configured to provide a user interface for the electronic instrument or can be connected to an interface of the electronic instrument. Preferably, the first function of the input key comprises activating a first mode of the electronic instrument, and the second function of the input key comprises activating a second mode of the electronic instrument.

Preferably, the graphical element indicates how long it takes to reach the threshold time value. The display of the graphical element can be triggered by the key press.

The input key can be a physical key, for example a push-button or a switch. In particular, the input key is adapted to change its position and/or its state if it is pressed, and to return to its initial position and/or its initial state after it is released. For example, the input key is arranged on a front panel of an electronic instrument in which the user interface control device is integrated.

The processor can be a microprocessor, in particular of the electronic instrument. For example, the processor is configured to initiate a timer after registering the starting time of the key press, wherein the timer registers the duration until the key is released. The processor can stop the timer when the input key is released. The processor can be configured to detect a short press if the timer was stopped before reaching the threshold value, and to detect a long press if the timer was stopped after reaching the threshold value. For example, to register if the input key is pressed, the processor can receive a signal from the input key for as long as the key is pressed.

In an embodiment, the graphical element comprises a progress bar, a countdown, and/or a timer display.

This achieves the advantage that a visual feedback on the required pressing time to execute the second function of the key can be provided to the user and, thus, operating errors or incorrect settings can be avoided. The progress bar, the countdown, and/or the timer display can be designed to indicate for how much longer the input key needs to be pressed to reach the threshold time value.

In an embodiment, the display is configured to display, at any time during a key press, a graphical or textual representation of the respective first or second function that is assigned to the input key if the input key is released at that time.

This achieves the advantage that a visual feedback on the current function of the input key, e.g. the activation of a certain mode of an electronic instrument, can be provided to the user and, thus, operating errors or incorrect settings can be avoided.

In an embodiment, upon releasing the input key, the display is configured to indicate the respective function that is assigned to the input key by the processor.

This achieves the advantage that a visual feedback on the function that will be executed, e.g. the activation of a certain mode of an electronic instrument, can be provided to the user and, thus, operating errors or incorrect settings can be avoided.

In an embodiment, the user interface control device is configured to receive a configuration input, in particular via a dedicated interface of the user interface control device.

This achieves the advantage that the function of the input key can be configured according to different user habits or requirements. The interface can comprise an input element, e.g. a touch-screen or a keyboard, on which the user can enter the configuration input. The user interface can further be configured to connect to an external electronic device, e.g. a laptop, for receiving the configuration input.

In an embodiment, the processor is configured to adjust the threshold time value based on the configuration input.

This achieves the advantage that the function of the input key can efficiently be configured according to different user habits or requirements.

In an embodiment, the processor is configured to define the first and/or second function of the input key based on the configuration input.

This achieves the advantage that the function of the input key can efficiently be configured according to different user habits or requirements. For instance, the processor can define which modes of an electronic instrument are activated by the first and/or second function of the key.

In an embodiment, the input key is a hard key or a soft key.

Preferably, the hard key is a key that has a dedicated function, wherein the soft key is a programmable key that can invoke different functions according to its programming. For example, a soft key can be a blank key in the vicinity of the display, wherein the display indicates the current function of the soft key.

In an embodiment, the input key comprises a user interface control element. In particular, the interface control element is a software button.

This achieves the advantage that no physical key is required, which reduces the overall costs of the device.

In an embodiment, the display is a touch display, and the input key is displayed in the touch display.

This achieves the advantage that no physical key is required, which reduces the overall costs of the device. Preferably, pressing the input key refers to touching the graphical button on the screen.

The electronic instruments comprises channels for receiving and/or forwarding signals, wherein the first function of the input key comprises activating a channel preset mode of the electronic instrument, and wherein the second function of the input key comprises activating a device preset mode of the electronic instrument.

Preferably, the signals are electrical signals, optical signals or acoustic signals. The signals can be a radio frequency (RF) signals. The first and second mode can refer to first and second settings or parameters of the electronic instrument for analyzing or generating signals. In particular, both modes are frequently used, so it is advantageous that they can be activated quickly and intuitively.

The electronic instrument can comprise a connector, e.g. a plug, to which another device, which generates or receives the signal, can be connected.

The electronic instrument is a spectrum analyzer.

The electronic instrument is a measurement device which can be configured to analyze the measurement signal based on the activated first or second mode. This may refer to analyzing the signal based on conditions, functions or settings of the electronic measurement device that are associated with the first or second mode, for example predefined or default measurement parameters.

For example, the electronic instrument is a spectrum analyzer, which is configured to analyze various properties of a signal, such as a spectrum, in particular spectral components, a power, a bandwidth and/or harmonics of the signal. For example, the measurement signal is an RF signal. The spectrum analyzer can comprise one or several measurement channels. For example, each measurement port of the spectrum analyzer can be associated with a measurement channel of the spectrum analyzer.

In particular, in the channel preset mode and/or the device preset mode the spectrum analyzer is set to predefined or default settings. These predefined or default settings can be stored in a memory of the device.

In the channel preset mode, a currently selected measurement channel of the spectrum analyzer is preset to a default configuration, e.g. default measurement parameters or a default resolution. In the device preset mode, all channels of the spectrum analyzer are preset to a default configuration.

Further, the electronic instrument can be configured to process the signal, e.g. to amplify the signal, and/or to display the signal in a display element of the device, e.g. the same display that is used to display the graphical element.

According to a second aspect, the invention relates to method for controlling a user interface of an electronic instrument, wherein the electronic instrument is a spectrum analyzer which comprises channels for receiving and/or forwarding RF signals, the method comprising:
- pressing an input key;
- registering a starting time and a duration of the key press on the input key;
- assigning a first function to the input key if the duration of the key press is shorter or equal to a threshold time value;
- assigning a second function to the input key if the duration of the key press exceeds the threshold time value; and
- displaying a graphical element, which indicates a duration of the key press at least until the threshold time value is reached,
wherein the first function of the input key comprises activating a channel preset mode of the electronic instrument and wherein the second function of the input key comprises activating a device preset mode of the electronic instrument, wherein, in the channel preset mode, a currently selected channel of the electronic instrument is preset to a default configuration, and in the device preset mode, all channels of the electronic instrument are preset to a default configuration.

This achieves the advantage that a simple and intuitive control scheme for a user interface, e.g. the user interface of an electronic instrument, can be provided. In particular, because a single input key can have different functions, no extra keys for each function is required. Due to the visual feedback during pushing the key, the user knows which function is assigned to the key when it is released and, thus, wrong user input can be avoided.

In particular, the method may comprise the further step:
- analyzing and/or generating a signal based on the activated first and/or second mode.

The above description with regard to the electronic instrument according to the first aspect of the invention is correspondingly valid for the method for controlling the user interface according to the second aspect of the invention.

### BRIEF DESCRIPTION OF THE DRAWINGS

The invention will be explained in the followings together with the figures.
- Fig. 1: shows a schematic diagram of a user interface control device according to an embodiment;
- Fig. 2: shows a schematic diagram of an electronic instrument according to an embodiment;
- Fig. 3a-c: show schematic diagrams of three display screens according to further embodiments; and
- Fig. 4: shows a schematic diagram of a method for controlling a user interface according to an embodiment.

### DETAILED DESCRIPTION OF THE PREFERRED EMBODIMENTS

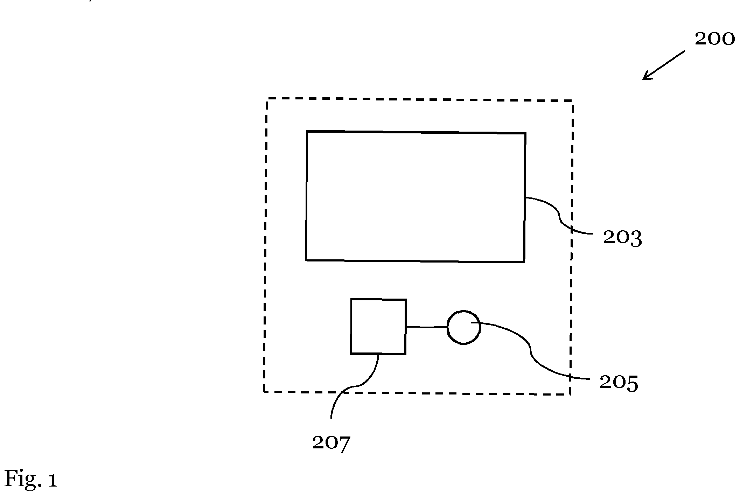

Fig. 1 shows a schematic diagram of a user interface control device 200 according to an embodiment.

The user interface control device 200, comprising: a display 203; an input key 205 that can be pressed by a user, and a processor 207 configured to register a starting time and a duration of a key press on the input key 205. The processor 207 is configured to assign a first function to the input key if the duration of the key press is shorter or equal to a threshold time value, and to assign a second function to the input key if the duration of the key press exceeds the threshold time value. Thereby, the display 203 is configured to display a graphical element, which indicates a duration of the key press at least until the threshold time value is reached.

The user interface control device 200 can be a component of an electronic instrument, for example a measurement device or a signal generator. The user interface control device 200 can be configured to provide a user interface for controlling the instrument or can be connected to a user interface of the electronic instrument. For example, the first function of the input key corresponds to activating a first mode of the electronic instrument and the second function of the input key corresponds to activating a second mode of the electronic instrument.

The input key 205 can be a physical key, for example a push-button or a switch. The input key can be a hard key or a soft key.

The display 203 can be a touch display. The input key 205 can be a user interface control element that is displayed in the touch display.

The processor 207 can be a microprocessor. For example, the processor 207 is configured to initiate a timer after registering the starting time of the key press, wherein the timer registers the duration until the key 205 is released.

The user interface control device 200 can be configurable. For example, the threshold time value, and/or the first and second functions themselves can be configured. Preferably, the user interface control device 200 comprises a dedicated interface (not shown in Fig. 1) for receiving such configuration input.

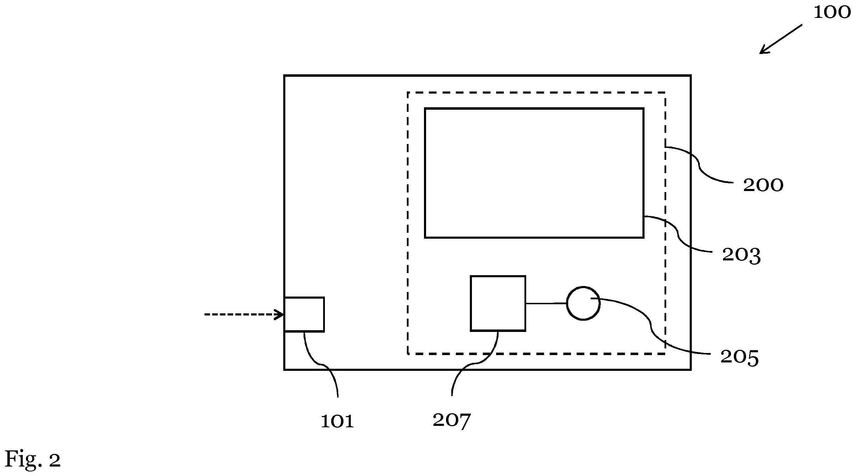

Fig. 2 shows a schematic diagram of an electronic instrument 100 comprising the user interface control device 200 according to an embodiment.

Preferably, the first function of the input key 205 comprises activating a first mode of the electronic instrument 100 and the second function of the input key 205 comprises activating a second mode of the electronic instrument 100.

The electronic instrument 100 can be a measurement device that comprises at least one measurement port 101 configured to receive a measurement signal to be analyzed by the electronic instrument. The electronic instrument 100 can be configured to analyze the measurement signal based on a first or second mode of the instrument activated via the input key.

For example, the electronic instrument 100 shown in Fig. 2 is a spectrum analyzer. The spectrum analyzer 100 can be configured to analyze various properties of the measurement signal, such as a spectrum, in particular spectral components, a power, a bandwidth and/or harmonics of the signal. For example, the measurement signal is an electrical signal and/or an RF signal.

The spectrum analyzer 100 can comprise one or several measurement channels. For example, each measurement port 101 of the spectrum analyzer can be associated with a measurement channel of the spectrum analyzer. A different source for a measurement signal to be analyzed by the measurement device 100 can be connected to each measurement port 101.

The first mode can be a channel preset mode of the spectrum analyzer 100, and/or the second mode can be a device preset mode of the spectrum analyzer 100. For example, in the channel preset mode, a currently selected measurement channel of spectrum analyzer 100 is preset to a default configuration, e.g. default measurement parameters or a default resolution. In the device preset mode, all channels of the spectrum analyzer 100 can be preset to a default configuration.

Alternatively, the electronic instrument 100 can be a signal generator that is configured to generate a signal, e.g. an electronic signal, based on the set mode.

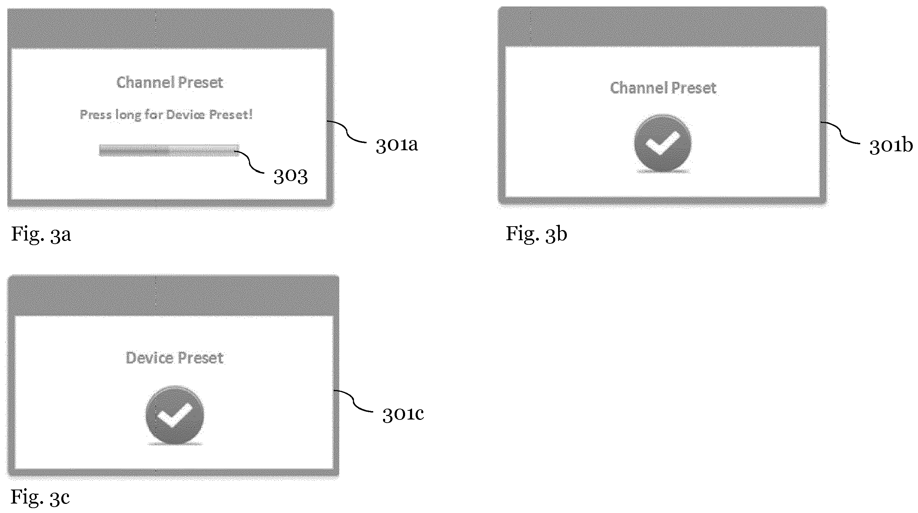

Fig. 3a-c show schematic diagrams of three display screens 301a-c according to a further embodiment. The display screens 301a-c in Figs. 3a-c are, for instance, displayed in the display 203 of the user interface control device 200 and/or the electronic instrument 100 during or after a key press on the respective input key 205.

Fig. 3a shows a display screens 301a during the key press before the threshold time value is reached. The display screen 301a shows a graphical element 303 in the form of a progress bar which indicates how long the input key 205 has been pressed and when the threshold time value will be reached. Alternatively, to the progress bar, the graphical element 303 can be a countdown or a timer display. In this way, the user knows for how long he has to press the input key 205 to assign different functions to the key 205.

The processor 207 can be configured to control the display 203 to display the graphical element 303, as soon as the processor 207 registers that the input key 205, 205 was pressed.

For example, the threshold time value is 3, 5, or 10 seconds.

Preferably, the display screen 301 also indicates, for instance via a textual representation, which mode of an electronic instrument 100 will be activated if the input key 205 is released prior to reaching the threshold time value, and which mode of the instrument 100 will be activated if the input key 205 is released after reaching the threshold time value. In this way, the user knows at any time which mode will be activated if he releases the key.

Fig. 3b shows a display screen 301b after releasing the input key 205 prior to reaching the threshold time value, and Fig. 3c shows a display screen 301c after releasing the input key 205 after reaching the threshold time value.

In both cases, the display 203 indicates which mode of the electronic instrument 100 is selected, for instance a device preset mode or a channel preset mode.

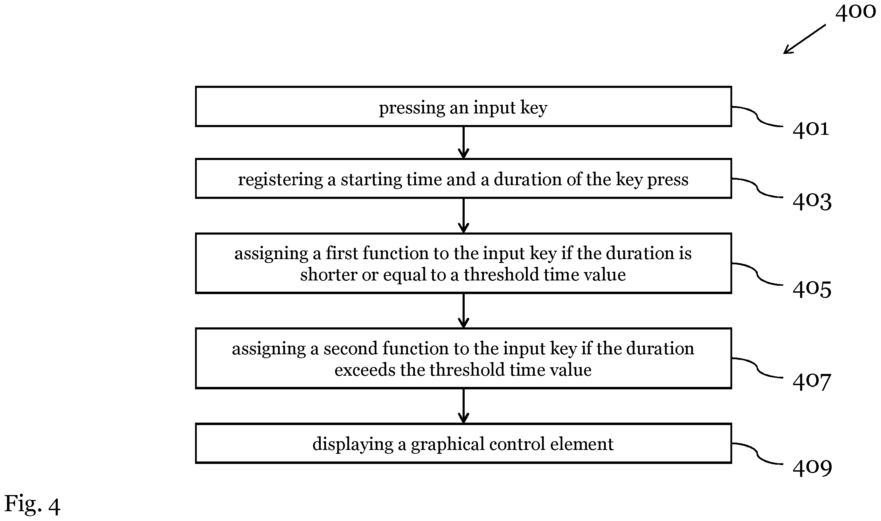

Fig. 4 shows a schematic diagram of a method 400 for controlling a user interface according to an embodiment. For example, the method 400 can be used to control a user interface control device, such as the device 100 shown in Fig. 1.

The method 400 comprises the following steps:
- pressing 401 the input key 205;
- registering 403 the starting time and the duration of the key press on the input key 205;
- assigning 405 a first function to the input key 205 if the duration of the key press is shorter or equal to a threshold time value;
- assigning 407 a second function to the input key 205 if the duration of the key press exceeds the threshold time value; and
- displaying 409 a graphical element 303, which indicates a duration of the key press at least until the threshold time value is reached.

The user interface can be that of an electronic instrument, for example the electronic instrument 100 shown in Fig. 2. The first function of the input key can comprise activating a first mode of the electronic instrument 100, and the second function of the input key can comprise activating a second mode of the electronic instrument 100. In particular, the method 400 can be a method for controlling the electronic instrument 100.

Preferably, the method 400 further comprises the steps:
- analyzing and/or generating a signal, preferably with the electronic instrument 100, based on the activated first or second mode.

If the electronic instrument 100 is a measurement device, the method can further comprise the step:
- receiving the measurement signal to be analyzed by the electronic instrument 100.

## Claims

1. An electronic measurement device (100), wherein the electronic measurement device (100) is a spectrum analyzer comprising:
channels for receiving and/or forwarding RF signals;
a user interface control device (200), said user interface control device (200) comprising:
a display (203);
an input key (205) that can be pressed by a user, and
a processor (207) configured to register a starting time and a duration of a key press on the input key (205),
wherein the processor (207) is configured to assign a first function to the input key if the duration of the key press is shorter or equal to a threshold time value, and wherein the processor (207) is configured assign a second function to the input key (205) if the duration of the key press exceeds the threshold time value,
wherein the display (203) is configured to display a graphical element (303), which indicates a duration of the key press at least until the threshold time value is reached, and
wherein the first function of the input key (205) comprises activating a channel preset mode of the electronic measurement device (100) and wherein the second function of the input key (205) comprises activating a device preset mode of the electronic measurement device (100),
wherein, in the channel preset mode, a currently selected channel of the electronic measurement device (100) is preset to a default configuration, and in the device preset mode, all channels of the electronic measurement device (100) are preset to a default configuration.

2. The electronic measurement device (100) of claim 1, wherein the graphical element (303) comprises a progress bar, a countdown, and/or a timer display.

3. The electronic measurement device (100) of claim 1 or 2, wherein the display (203) is configured to display, at any time during a key press, a graphical or textual representation of the respective first or second function that is assigned to the input key (205) if the input key (205) is released at that time.

4. The electronic measurement device (100) of any of claims 1 to 3, wherein upon releasing the input key (205), the display (203) is configured to indicate the respective function that is assigned to the input key (205) by the processor (207).

5. The electronic measurement device (100) of any of claims 1 to 4, wherein the user interface control device (200) is configured to receive a configuration input.

6. The electronic measurement device (100) of claim 5, wherein the processor (207) is configured to adjust the threshold time value based on the configuration input.

7. The electronic measurement device (100) of claim 5 or 6, wherein the processor (207) is configured to define the first and/or second function of the input key (205) based on the configuration input.

8. The electronic measurement device (100) of any of claims 1 to 7, wherein the input key (205) is a hard key or a soft key.

9. The electronic measurement device (100) of any of claims 1 to 8, wherein input key (205) comprises a user interface control element.

10. The electronic measurement device (100) of any of claims 1 to 9, wherein the display (203) is a touch display, and wherein the input key (205) is displayed in the touch display.

11. A method (400) for controlling a user interface of an electronic measurement device (100), wherein the electronic measurement device (100) is a spectrum analyzer which comprises channels for receiving and/or forwarding RF signals, the method comprising:
- pressing (401) an input key (205);
- registering (403) a starting time and a duration of the key press on the input key (205);
- assigning (405) a first function to the input key (205) if the duration of the key press is shorter or equal to a threshold time value;
- assigning (407) a second function to the input key (205) if the duration of the key press exceeds the threshold time value; and
- displaying (409) a graphical element (303), which indicates a duration of the key press at least until the threshold time value is reached;
wherein the first function of the input key (205) comprises activating a channel preset mode of the electronic measurement device (100) and wherein the second function of the input key (205) comprises activating a device preset mode of the electronic measurement device (100),
wherein, in the channel preset mode, a currently selected channel of the electronic measurement device (100) is preset to a default configuration, and in the device preset mode, all channels of the electronic measurement device (100) are preset to a default configuration.

## Patentansprüche

1. Elektronische Messvorrichtung (100), wobei die elektronische Messvorrichtung (100) ein Spektrumanalysator ist, umfassend:
Kanäle zum Empfangen und/oder Weiterleiten von HF-Signalen;
eine Benutzerschnittstellensteuervorrichtung (200), die Benutzerschnittstellensteuervorrichtung (200) umfassend:
eine Anzeige (203);
eine Eingabetaste (205), die durch einen Benutzer gedrückt werden kann, und
einen Prozessor (207), der konfiguriert ist, um einen Startzeitpunkt und eine Dauer eines Tastendrucks auf der Eingabetaste (205) zu registrieren,
wobei der Prozessor (207) konfiguriert ist, um der Eingabetaste eine erste Funktion zuzuweisen, falls die Dauer des Tastendrucks kürzer als oder gleich einem Schwellenzeitwert ist, und wobei der Prozessor (207) konfiguriert ist, um der Eingabetaste (205) eine zweite Funktion zuzuweisen, falls die Dauer des Tastendrucks den Schwellenzeitwert überschreitet,
wobei die Anzeige (203) konfiguriert ist, um ein grafisches Element (303) anzuzeigen, das eine Dauer des Tastendrucks mindestens angibt, bis der Schwellenzeitwert erreicht ist, und
wobei die erste Funktion der Eingabetaste (205) ein Aktivieren eines Kanalvoreinstellungsmodus der elektronischen Messvorrichtung (100) umfasst und wobei die zweite Funktion der Eingabetaste (205) das Aktivieren eines Vorrichtungsvoreinstellungsmodus der elektronischen Messvorrichtung (100) umfasst,
wobei, in dem Kanalvoreinstellungsmodus, ein aktuell ausgewählter Kanal der elektronischen Messvorrichtung (100) auf eine Standardkonfiguration voreingestellt ist und in dem Vorrichtungsvoreinstellungsmodus alle Kanäle der elektronischen Messvorrichtung (100) auf eine Standardkonfiguration voreingestellt sind.

2. Elektronische Messvorrichtung (100) nach Anspruch 1, wobei das grafische Element (303) einen Fortschrittsbalken, einen Countdown und/oder eine Timeranzeige umfasst.

3. Elektronische Messvorrichtung (100) nach Anspruch 1 oder 2, wobei die Anzeige (203) konfiguriert ist, um, zu einem beliebigen Zeitpunkt während eines Tastendrucks, eine grafische oder textliche Darstellung der jeweiligen ersten oder zweiten Funktion anzuzeigen, die der Eingabetaste (205) zugewiesen ist, falls die Eingabetaste (205) zu diesem Zeitpunkt losgelassen wird.

4. Elektronische Messvorrichtung (100) nach einem der Ansprüche 1 bis 3, wobei bei dem Loslassen der Eingabetaste (205) die Anzeige (203) konfiguriert ist, um die jeweilige Funktion anzugeben, die der Eingabetaste (205) durch den Prozessor (207) zugewiesen wurde.

5. Elektronische Messvorrichtung (100) nach einem der Ansprüche 1 bis 4, wobei die Benutzerschnittstellensteuervorrichtung (200) konfiguriert ist, um eine Konfigurationseingabe zu empfangen.

6. Elektronische Messvorrichtung (100) nach Anspruch 5, wobei der Prozessor (207) konfiguriert ist, um den Schwellenzeitwert basierend auf der Konfigurationseingabe anzupassen.

7. Elektronische Messvorrichtung (100) nach Anspruch 5 oder 6, wobei der Prozessor (207) konfiguriert ist, um die erste und/oder die zweite Funktion der Eingabetaste (205) basierend auf der Konfigurationseingabe zu definieren.

8. Elektronische Messvorrichtung (100) nach einem der Ansprüche 1 bis 7, wobei die Eingabetaste (205) eine Hard- oder eine Soft-Taste ist.

9. Elektronische Messvorrichtung (100) nach einem der Ansprüche 1 bis 8, wobei die Eingabetaste (205) ein Benutzerschnittstellensteuerelement umfasst.

10. Elektronische Messvorrichtung (100) nach einem der Ansprüche 1 bis 9, wobei die Anzeige (203) eine Berührungsanzeige ist und wobei die Eingabetaste (205) in der Berührungsanzeige angezeigt wird.

11. Verfahren (400) zum Steuern einer Benutzerschnittstelle einer elektronischen Messvorrichtung (100), wobei die elektronische Messvorrichtung (100) ein Spektrumanalysator ist, der Kanäle zum Empfangen und/oder Weiterleiten von HF-Signalen umfasst, das Verfahren umfassend:
- Drücken (401) einer Eingabetaste (205);
- Registrieren (403) eines Startzeitpunkts und einer Dauer des Tastendrucks auf der Eingabetaste (205);
- Zuweisen (405) einer ersten Funktion zu der Eingabetaste (205), falls die Dauer des Tastendrucks kürzer als oder gleich einem Schwellenzeitwert ist;
- Zuweisen (407) einer zweiten Funktion zu der Eingabetaste (205), falls die Dauer des Tastendrucks den Schwellenzeitwert überschreitet; und
- Anzeigen (409) eines grafischen Elements (303), das eine Dauer des Tastendrucks mindestens angibt, bis der Schwellenzeitwert erreicht ist;
wobei die erste Funktion der Eingabetaste (205) ein Aktivieren eines Kanalvoreinstellungsmodus der elektronischen Messvorrichtung (100) umfasst und wobei die zweite Funktion der Eingabetaste (205) das Aktivieren eines Vorrichtungsvoreinstellungsmodus der elektronischen Messvorrichtung (100) umfasst,
wobei, in dem Kanalvoreinstellungsmodus, ein aktuell ausgewählter Kanal der elektronischen Messvorrichtung (100) auf eine Standardkonfiguration voreingestellt ist und in dem Vorrichtungsvoreinstellungsmodus alle Kanäle der elektronischen Messvorrichtung (100) auf eine Standardkonfiguration voreingestellt sind.

## Revendications

1. Dispositif de mesure électronique (100), dans lequel le dispositif de mesure électronique (100) est un analyseur de spectre comprenant :
des canaux permettant de recevoir et/ou d'acheminer des signaux RF ;
un dispositif de commande d'interface utilisateur (200), ledit dispositif de commande d'interface utilisateur (200) comprenant :
un affichage (203) ;
une touche d'entrée (205) qui peut être pressée par un utilisateur, et
un processeur (207) configuré pour enregistrer un moment de début et une durée d'une pression de touche sur la touche d'entrée (205),
dans lequel le processeur (207) est configuré pour attribuer une première fonction à la touche d'entrée si la durée de la pression de touche est plus courte que, ou égale à, une valeur seuil de temps, et dans lequel le processeur (207) est configuré pour attribuer une seconde fonction à la touche d'entrée (205) si la durée de la pression de touche dépasse la valeur seuil de temps,
dans lequel l'affichage (203) est configuré pour afficher un élément graphique (303), qui indique une durée de la pression de touche au moins jusqu'à ce que la valeur seuil de temps soit atteinte, et
dans lequel la première fonction de la touche d'entrée (205) comprend l'activation d'un mode de préréglage de canal du dispositif de mesure électronique (100) et dans lequel la seconde fonction de la touche d'entrée (205) comprend l'activation d'un mode de préréglage de dispositif du dispositif de mesure électronique (100),
dans lequel, dans le mode de préréglage de canal, un canal actuellement sélectionné du dispositif de mesure électronique (100) est préréglé à une configuration par défaut, et dans le mode de préréglage de dispositif, tous les canaux du dispositif de mesure électronique (100) sont préréglés à une configuration par défaut.

2. Dispositif de mesure électronique (100) selon la revendication 1, dans lequel l'élément graphique (303) comprend une barre de progression, un compte à rebours, et/ou un affichage de temporisateur.

3. Dispositif de mesure électronique (100) selon la revendication 1 ou 2, dans lequel l'affichage (203) est configuré pour afficher, à n'importe quel moment pendant une pression de touche, une représentation graphique ou textuelle de la première ou seconde fonction respective qui est attribuée à la touche d'entrée (205) si la touche d'entrée (205) est relâchée à ce moment.

4. Dispositif de mesure électronique (100) selon l'une quelconque des revendications 1 à 3, dans lequel lors d'un relâchement de la touche d'entrée (205), l'affichage (203) est configuré pour indiquer la fonction respective qui est attribuée à la touche d'entrée (205) par le processeur (207).

5. Dispositif de mesure électronique (100) selon l'une quelconque des revendications 1 à 4, dans lequel le dispositif de commande d'interface utilisateur (200) est configuré pour recevoir une entrée de configuration.

6. Dispositif de mesure électronique (100) selon la revendication 5, dans lequel le processeur (207) est configuré pour ajuster la valeur seuil de temps en fonction de l'entrée de configuration.

7. Dispositif de mesure électronique (100) selon la revendication 5 ou 6, dans lequel le processeur (207) est configuré pour définir la première et/ou la seconde fonction de la touche d'entrée (205) en fonction de l'entrée de configuration.

8. Dispositif de mesure électronique (100) selon l'une quelconque des revendications 1 à 7, dans lequel la touche d'entrée (205) est une touche matérielle ou une touche logicielle.

9. Dispositif de mesure électronique (100) selon l'une quelconque des revendications 1 à 8, dans lequel la touche d'entrée (205) comprend un élément de commande d'interface utilisateur.

10. Dispositif de mesure électronique (100) selon l'une quelconque des revendications 1 à 9, dans lequel l'affichage (203) est un affichage tactile, et dans lequel la touche d'entrée (205) est affichée sur l'affichage tactile.

11. Procédé (400) permettant de commander une interface utilisateur d'un dispositif de mesure électronique (100), dans lequel le dispositif de mesure électronique (100) est un analyseur de spectre qui comprend des canaux permettant de recevoir et/ou d'acheminer des signaux RF, le procédé comprenant :
- une pression (401) sur une touche d'entrée (205) ;
- l'enregistrement (403) d'un moment de début et d'une durée de la pression de touche sur la touche d'entrée (205) ;
- l'attribution (405) d'une première fonction à la touche d'entrée (205) si la durée de la pression de touche est plus courte que, ou égale à, une valeur seuil de temps ;
- l'attribution (407) d'une seconde fonction à la touche d'entrée (205) si la durée de la pression de touche dépasse la valeur seuil de temps ; et
- l'affichage (409) d'un élément graphique (303), qui indique une durée de la pression de touche au moins jusqu'à ce que la valeur seuil de temps soit atteinte ;
dans lequel la première fonction de la touche d'entrée (205) comprend l'activation d'un mode de préréglage de canal du dispositif de mesure électronique (100) et dans lequel la seconde fonction de la touche d'entrée (205) comprend l'activation d'un mode de préréglage de dispositif du dispositif de mesure électronique (100),
dans lequel, dans le mode de préréglage de canal, un canal actuellement sélectionné du dispositif de mesure électronique (100) est préréglé à une configuration par défaut, et dans le mode de préréglage de dispositif, tous les canaux du dispositif de mesure électronique (100) sont préréglés à une configuration par défaut.
